# EUROPEAN PATENT APPLICATION

(11) **EP 1 659 452 A1**
(43) Date of publication of application: **24.05.2006**
(21) Application number: 05257154.4
(22) Date of filing: 21.11.2005
(51) Int. Cl.: G03F 7/20, G03F 9/00

(54) **Latent overlay metrology**

(30) Priority: 22.11.2004 US 993416
(71) Applicant: ASML Netherlands B.V., 5504 DR Veldhoven (NL)
(72) Inventor: Den Boef, Arie Jeffrey, 5581 NA Waalre (NL); Burghoorn, Jacobus, 6081 AS Haelen (NL); Dusa, Mircea, Campbell, CA 95008-5134 (US); Kiers, Antoine Gaston Marie, 550 DW Veldhoven (NL); Van der Schaar, Maurits, 5508 CP Veldhoven (NL)
(74) Representative: Leeming, John Gerard

(57) **Abstract**

An apparatus and method for improved latent overlay metrology is disclosed. In an embodiment, a scatterometer and an overexposed overlay target are used to obtain more robust overlay measurement. Overlay metrology and exposure may be done in parallel.

## Description

The present invention relates to the use of metrology for measuring alignment and overlay of substrates and more specifically, for its use in a lithographic apparatus.

A lithographic apparatus is a machine that applies a desired pattern onto a portion of a substrate. Lithographic apparatus can be used, for example, in the manufacture of integrated circuits (ICs), flat panel displays and other devices involving fine structures. In a conventional lithographic apparatus, a patterning device, which is alternatively referred to as a mask or a reticle, may be used to generate a pattern corresponding to an individual layer of the IC (or other device), and this pattern can be imaged onto a portion (e.g. comprising part of, one or several dies) on a substrate (e.g. a silicon wafer or glass plate) that has a layer of radiation-sensitive material (resist). Instead of a mask, the patterning device may comprise, among other things, an array of individually controllable elements which serve to generate the pattern.

In general, a single substrate will contain a network of adjacent portions that are successively exposed. Known lithographic apparatus include so-called steppers, in which each portion is irradiated by exposing an entire pattern onto the portion at one time, and so-called scanners, in which each portion is irradiated by scanning the pattern through the projection beam in a given direction (the "scanning"-direction) while synchronously scanning the substrate parallel or anti-parallel to this direction.

The portions will each be exposed several times in order to build up the complete pattern. These successive layers should be aligned to minimize errors in the complete pattern. In order to determine the extent of errors in the alignment, measurement of the overlay of one layer with respect to another is carried out using, for example, overlay metrology (i.e., overlay metrology of overlay targets). This may comprise a scatterometer that measures radiation that has scattered off a target and compares it with library data to determine if there is an overlay error.

Known methods of metrology involve dedicating a part of a substrate to alignment marks or targets, which are printed on each resist layer in order to be visible for alignment prior to each scanning process..

The problem with the state of the art is that the latent contrast of the marks is too weak, certainly to be useful through several layers of resist. Furthermore, large areas of usable substrate are wasted on alignment marks and throughput is low because of the separate processes of alignment and exposure.

To solve these problems, according to an aspect of the present invention, there is provided a lithographic apparatus, comprising:
an illumination system configured to condition a beam of radiation;
a support configured to hold a patterning device, the patterning device configured to impart the beam with a pattern in its cross-section;
a substrate table configured to hold a substrate;
   a projection system configured to project the patterned beam onto a portion of the substrate; and
   an exposure unit, including an additional patterning device, configured to print a target onto the substrate.

The target may be used for alignment and for overlay metrology applications. By using an exposure unit configured to print a target onto the substrate, targets no longer need to be present in the pattern and need not be printed on every portion exposed on the substrate, saving scribelane space and offering more flexibility. In an embodiment, a target exposed with a higher exposure dose than the normal exposure dose may make measuring the overlay of a latent image easier. The latent image may be created by using radiation and no chemical developers. A latent image may be hardly detectable in the resist layer but by using the high-exposure dose/energy unit it may become better detectable.

The exposure unit may be configured to supply radiation of a wavelength of 193 nm with an exposure dose of more than 30 mJ/cm²; radiation of a wavelength of 193 nm with an exposure dose of more than 100 mJ/cm²; radiation of a wavelength of 248 nm with an exposure dose of more than 50 mJ/cm²; radiation of a wavelength of 248 nm with an exposure dose of more than 150 mJ/cm²; radiation of a wavelength of 365 nm with an exposure dose of more than 200 mJ/cm²; or radiation of a wavelength of 365 nm with an exposure dose of more than 400 mJ/cm².

According to another aspect of the present invention, there is provided a method of measuring latent overlay of a resist layer with respect to a process layer on a substrate, comprising:
measuring a position of a substrate with respect to a reference;
exposing a target in the resist layer with beam of radiation having a high exposure dose in accordance with the measured position of the substrate; and
   measuring the overlay of the resist layer with respect to the process layer at the exposed target.

An illumination source and a mask may be used to produce the target. Alternatively, an illumination source and a spatial light modulator amay be used to produce the target.

The overlay may be measured using an angle-resolved scatterometer and the target may comprise a latent phase-shift grating.

The high exposure dose may be higher than a exposure dose used during normal exposure of the substrate in a lithographic apparatus.

The beam of radiation wavelength and the high exposure dose may be 193 nm and more than 30 mJ/cm² respectively; 193 nm more than 100 mJ/cm² respectively; 248 nm and more than 50 mJ/cm²; or 248 nm and more than 150 mJ/cm².

A process correction may be made in a feedforward manner based on the measurement of the overlay.

Exposing the target may take place at a measurement position displaced from an exposure position where a projection system of lithographic projection apparatus projects a patterned beam onto a portion of the substrate.

When aligning a resist layer on top of a previously exposed process layer (a process layer being a previously exposed and processed resist layer), a target may enable overlay metrology to be more easily carried out. Because a die is not exposed in the creation of the overlay target, large exposure energies may be possible, which could enhance the latent image of the overlay target. Further, use of a target in a scribe lane has an advantage of possibly avoiding taking measurements in areas outside of the substrate, creating a further possibility of error when extrapolating measurements from an external target to the substrate itself.

Overexposure of the overlay target may also provide a stronger latent contrast. For example, because of the chemical properties of the resist, the latent contrast of overlay targets created with a nominal exposure dose may sometimes be too weak to perform meaningful measurements with 193nm resist. This is because the changes taking place inside the resist at a nominal exposure dose is too small to induce a measurable refractive index change, causing the contrast to be weak. Accordingly, the latent image of the overexposed target may be more efficient to use for latent overlay metrology.

Further, in an embodiment, process corrections may be applied in a feedforward system (i.e. before a product layer is exposed) so that there is little or no decrease in throughput. Thus, this may provide an advantage in that the results of measurements on a substrate at a measurement stage (position) may be used to correct for variations at an exposure stage (position), where the substrate is subsequently exposed. It may be much more useful to be able to correct substrate n based on measurements from substrate n, not substrate n-1.

Local exposure in a scribelane may allow fine alignment and capture targets to be printed at only a few fields, saving on scribelane space. It also may allow for programmable alignment targets, optimizing the process without needing to provide new product masks for new alignment targets (as would have been the case when product masks with alignment targets were used to align the substrates, since an entire mask would have had to be replaced just to replace an alignment target). Focus monitoring may be made possible by printing gratings with a phase-shift grating.

The term "array of individually controllable elements" or "patterning device" as here employed should be broadly interpreted as referring to any device that can be used to endow an incoming radiation beam with a patterned cross-section, so that a desired pattern can be created in a portion of the substrate; the terms "light valve" and "spatial light modulator" (SLM) can also be used in this context. Examples of such patterning devices include:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the undiffracted light can be filtered out of the reflected beam, leaving only the diffracted light to reach the substrate; in this manner, the beam becomes patterned according to the addressing pattern of the matrix-addressable surface. It will be appreciated that, as an alternative, the filter may filter out the diffracted light, leaving the undiffracted light to reach the substrate. An array of diffractive optical MEMS devices can also be used in a corresponding manner. Each diffractive optical MEMS device is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing a piezoelectric actuation device. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In the situations described hereabove, the array of individually controllable elements can comprise one or more programmable mirror arrays.

It should be appreciated that where pre-biasing of features, optical proximity correction features, phase variation techniques and multiple exposure techniques are used, for example, the pattern "displayed" on the array of individually controllable elements may differ substantially from the pattern eventually transferred to a layer of or on the substrate. Similarly, the complete pattern eventually generated on the substrate may not correspond to the pattern formed at any one instant on the array of individually controllable elements. This may be the case in an arrangement in which the eventual pattern formed on each part of the substrate is built up over a given period of time or a given number of exposures during which the pattern on the array of individually controllable elements and/or the relative position of the substrate changes.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat panel displays, thin-film magnetic heads, etc. The skilled artisan will appreciate that, in the context of such alternative applications, any use of the terms "wafer" or "die" herein may be considered as synonymous with the more general terms "substrate" or "portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 408, 355, 365, 248, 193, 157 or 126 nm) and extreme ultra-violet (EUV) radiation (e.g. having a wavelength in the range of 5-20 nm), as well as particle beams, such as ion beams or electron beams.

The term "proj ection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "projection lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables. In such "multiple stage" machines the additional tables may be used in parallel, or preparatory steps may be carried out on one or more tables while one or more other tables are being used for exposure. For example, one substrate table may be at a measurement position where the topography of the substrate is detected while the other substrate table is at the exposure position where the substrate is being exposed.

The lithographic apparatus may also be of a type wherein the substrate is immersed in a liquid having a relatively high refractive index, e.g. water, so as to fill a space between the final element of the projection system and the substrate. Immersion liquid may also be applied to other spaces in the lithographic apparatus, for example, between the array of individually controllable elements and the first element of the projection system. Immersion techniques are well known in the art for increasing the numerical aperture of projection systems.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figure 2 depicts a small field exposure branch of a scatterometer according to an embodiment of the invention;
Figures 3a-d depicts method steps according to an embodiment of the method of the invention;
Figure 4 depicts a change in resist layer thickness in the latent image as a function of the exposure dose of the high-energy exposure unit according to an embodiment of the invention;
Figure 5 depicts a change in resist refractive index in the latent image as a function of the exposure dose of the high-energy exposure unit according to an embodiment of the invention;
Figure 6 depicts a change in absorption coefficient in the latent image as a function of the exposure dose of the high-energy exposure unit according to an embodiment of the invention;
Figure 7 depicts a change in absorption coefficient in the latent image as a function of the exposure dose of the high energy exposure unit according to an embodiment of the invention after thermal treatment of the latent image;
Figure 8 depicts a small field exposure branch of a scatterometer and a measurement branch of a scatterometer according to a further embodiment of the invention; and
Figture 9 depicts shows the positioning of a plurality of transmission image sensor targets according to a further embodiment of the present invention.

### DETAILED DESCRIPTION

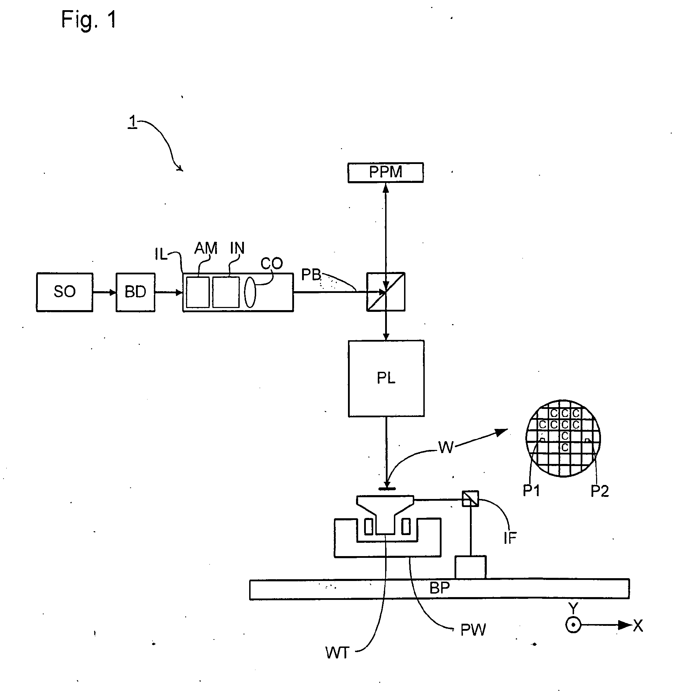

Figure 1 schematically depicts a lithographic projection apparatus according to a particular embodiment of the invention. The apparatus comprises:
- an illumination system (illuminator) IL configured to condition a beam PB of radiation (e.g. UV radiation);
- a support structure configured to hold a patterning device. In an embodiment, the patterning device comprises an array of individually controllable' elements PPM (e.g. a programmable mirror array) configured to apply a pattern to the beam; in general the position of the array of individually controllable elements will be fixed relative to projection system PL; however it may instead be connected to a positioning device configured to accurately position it with respect to the projection system PL;
- a substrate table (e.g. a wafer table) WT configured to hold a substrate (e.g. a resist-coated wafer) W, and connected to a positioning device PW configured to accurately position the substrate with respect to projection system PL; and
- a projection system ("projection lens") PL configured to image a pattern imparted to the beam PB by the array of individually controllable elements PPM onto a portion C (e.g. comprising one or more dies) of the substrate W; the projection system may image the array of individually controllable elements onto the substrate; alternatively, the projection system may image secondary sources for which the elements of the array of individually controllable elements act as shutters; the projection system may also comprise an array of focusing elements such as a micro lens array (known as an MLA) or a Fresnel lens array, e.g. to form the secondary sources and to image microspots onto the substrate.

As here depicted, the apparatus is of a reflective type (i.e. has a reflective array of individually controllable elements). However, in general, it may also be of a transmissive type, for example (i.e. with a transmissive array of individually controllable elements).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the beam PB, having a desired uniformity and intensity distribution in its cross-section.

The beam PB subsequently intercepts the array of individually controllable elements PPM. Having been reflected by the array of individually controllable elements PPM, the beam PB passes through the projection system PL, which focuses the beam PB onto a portion C of the substrate W. With the aid of the positioning device PW (and interferometric measuring device IF), the substrate table WT can be moved accurately, e.g. so as to position different portions C in the path of the beam PB. Where used, the positioning device for the array of individually controllable elements can be used to accurately correct the position of the array of individually controllable elements PPM with respect to the path of the beam PB, e.g. during a scan. The substrate W may be aligned using substrate alignment marks (targets) P1, P2. Although the substrate alignment marks as illustrated occupy dedicated portions, they may be located in spaces between portions (these are known as scribe-lane alignment marks). In general, movement of the substrate table WT is realized with the aid of a long-stroke module (coarse positioning) and a short-stroke module (fine positioning), which are not explicitly depicted in Figure 1. A similar system may also be used to position the array of individually controllable elements. It will be appreciated that the beam PB may, alternatively or additionally, be moveable while the substrate table and/or the array of individually controllable elements may have a fixed position to provide the required relative movement. As a further alternative, that may be especially applicable in the manufacture of flat panel displays, the position of the substrate table WT and the projection system PL may be fixed and the substrate may be arranged to be moved relative to the substrate table. For example, the substrate table WT may be provided with a system for scanning the substrate across it at a substantially constant velocity.

Although the lithography apparatus according to an embodiment of the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the array of individually controllable elements imparts an entire pattern to the projection beam, which is projected onto a portion C at one time (i.e. a single static exposure). The substrate table WT is then shifted in the X and/or Y direction so that a different portion C can be exposed. In step mode, the maximum size of the exposure field limits the size of the portion C imaged in a single static exposure.
2. Scan mode: the array of individually controllable elements is movable in a given direction (the so-called "scan direction", e.g. the Y direction) with a speed v, so that the beam PB is caused to scan over the array of individually controllable elements; concurrently, the substrate table WT is simultaneously moved in the same or opposite direction at a speed V = Mv, in which M is the magnification of the projection system PL. In scan mode, the maximum size of the exposure field limits the width (in the non-scanning direction) of the portion in a single dynamic exposure, whereas the length of the scanning motion determines the height (in the scanning direction) of the portion.
3. Pulse mode: the array of individually controllable elements is kept essentially stationary and the entire pattern is projected onto a portion C of the substrate using a pulsed radiation source. The substrate table WT is moved with an essentially constant speed such that the beam PB is caused to scan a line across the substrate W. The pattern on the array of individually controllable elements is updated as required between pulses of the radiation system and the pulses are timed such that successive portions C are exposed at the required locations on the substrate. Consequently, the beam PB can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the array of individually controllable elements is updated as the beam PB scans across the substrate and exposes it.

Combinations and/or variations on the above described modes of use or entirely different modes of use may also be employed.

A "dual stage" system comprises two separate stages, which contain two separate substrates simultaneously, increasing throughput. The first stage is a measurement stage, at which one or more properties (such as alignment) of the substrate and resist layer are measured so that when the substrate passes to the second stage, which is the exposure stage, the resist layer can be exposed based on the measurements at the first stage while a second substrate enters the measurement stage, and so on.

In order to verify the alignment of the resist layer with a process layer, a latent overexposed overlay target is printed in the scribelane. This is done by a high energy miniature exposure unit, at, for example, the measurement stage, which is associated with a scatterometer used to measure overlay and with an alignment measuring tool. Fewer targets of greater contrast may therefore be used. The large exposure energy may ensure sufficient signal contrast, and/or the miniature exposure unit may allow for the printing of only a few targets, which results in a saving of scribelane space.

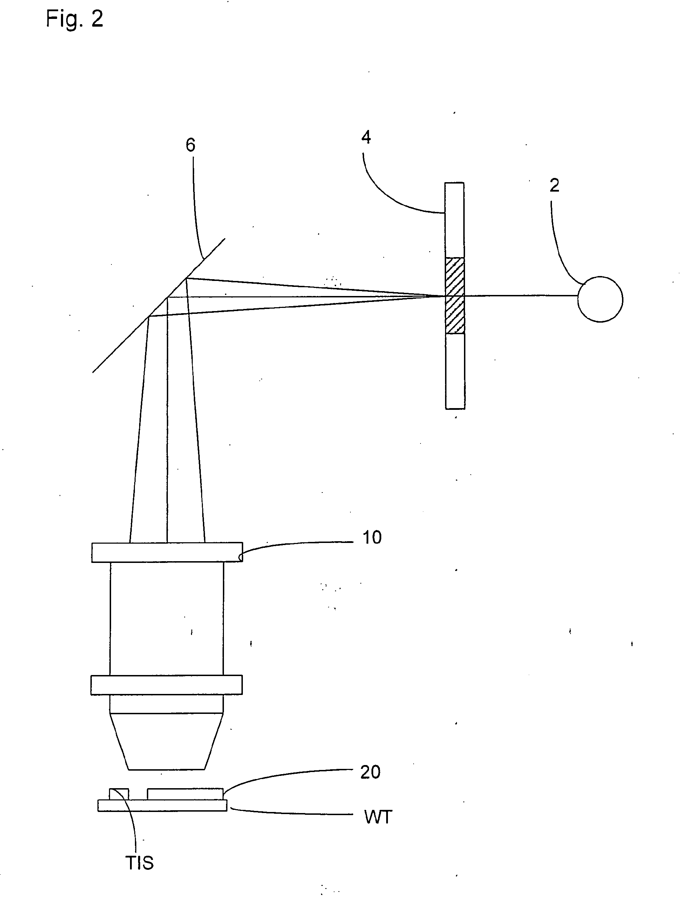

Figure 2 shows a high-numerical aperture lens of an angle-resolved scatterometer 10, which is used for measuring scattered radiation from a substrate 20 in order to determine a parameter, such as overlay, of the substrate surface. More information about a spectrometer suitable for an embodiment of the present invention can be found in US patent application no. 10/918,742, incorporated by reference herein in its entirety. Although Figure 2 shows an angle-resolved scatterometer, a spectroscopic scatterometer may also be used. The scatterometer 10 has added to it a small field exposure branch (a "miniature exposure unit" or a high-energy exposure unit) comprising a patterning device 4 and a narrow band mirror 6. In an embodiment, the miniature exposure unit may comprise a UV radiation source 2. UV radiation source 2 may be different from source SO or may instead be source SO. Where source SO is used to provide UV radiation to the illumination system and the miniature exposure unit, a fiber may be provided to transmit the UV radiation from the illumination system IL or the source SO to the miniature exposure unit. A control mechanism may be provided to instruct the source SO to provide a high dose and to channel the high dose radiation to the miniature exposure unit via the fiber. Appropriate software may be provided to control channeling of the high dose radiation to the miniature exposure unit so as to have no or small effect on the throughput of the lithographic apparatus (e.g., channeling high dose radiation to the miniature exposure unit during a time that the substrate steps as part of an exposure operation). As will be appreciated, the miniature exposure unit may be configured differently including possibly using the projection system PL. However, in an embodiment, a dedicated exposure unit is provided solely to print a target on the substrate.

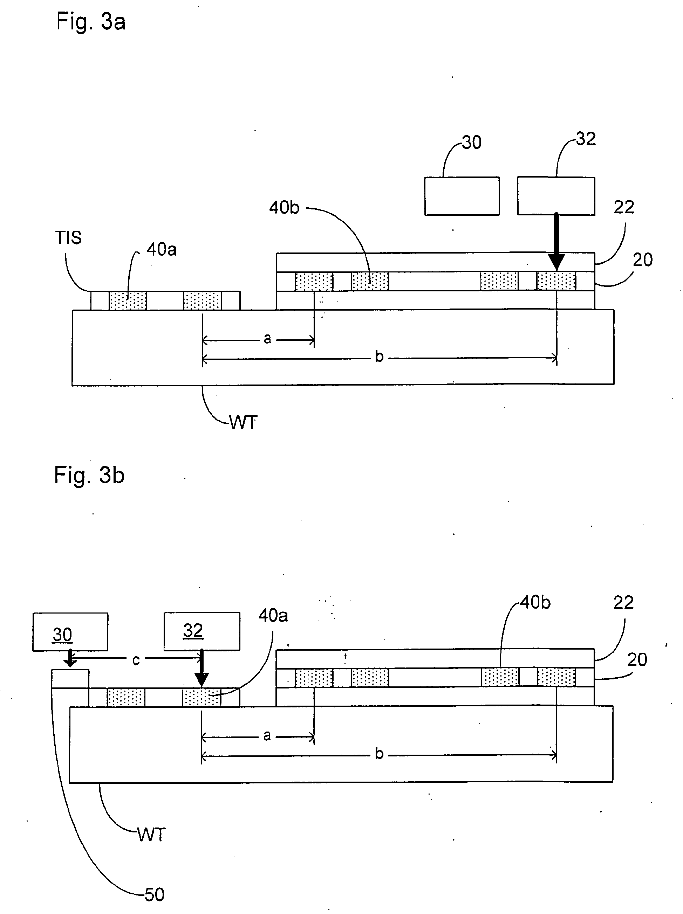

Figure 2 shows that the high-numerical aperture lens of the angle resolved scatterometer may also be used to image a small target in the scribe lane. In an embodiment, the target has a size less than 1 mm². In an embodiment, the target has, a size less than 2500 µm² and is exposed onto a scribelane of the substrate. The patterning device 4 can be a mask having a pattern to form the overlay target or a SLM to impart a pattern to the illumination beam to form the overlay target. In an embodiment, the patterning device 4 may be held on and moved using a moveable stage. The overlay target may exposed using scanning, stepping or other exposure techniques. It is this miniature exposure unit that creates the overlay target described in the steps shown in Figures 3a to 3d and described below.

In order to determine where the miniature exposure unit should expose the overlay target, an alignment tool is used to compare one or more previous alignment targets on the substrate with a reference, and use the measurements of the one or more previous alignment targets to establish where to expose the overlay target so that it is aligned with the previous target. This alignment tool is described below.

In addition to the substrate 20 on the substrate table WT, the substrate table WT comprises one or more transmission image sensors TIS which can be used to determine the lateral position and best focus position (i.e. horizontal and vertical position) of the projected image (for example, an alignment target) under the projection system or in the miniature exposure unit. A transmission image sensor TIS is inset into a physical reference surface associated with the substrate table WT. In an embodiment, two sensors are mounted on fiducial plates mounted to the substrate-bearing surface of the substrate table WT, at diagonally opposite positions outside the area covered by the substrate 20. Each fiducial plate is made of a highly stable material with a very low coefficient of thermal expansion, e.g. low-thermal expansion quartz, and has a flat reflective upper surface, which may carry one or more markers used with another fiducial in an alignment process.

The TIS is used to determine directly the vertical (and horizontal) position of an aerial image, e.g., of an alignment target, of the projection system or the miniature exposure unit. An advantage of a TIS alignment system includes robustness and speed because it is a direct measurement technique not involving exposure of a resist. In an embodiment, the TIS comprises a surface having one or more apertures, close behind the surface is a photodetector sensitive to the radiation used for the exposure process. To determine the position of the focal plane, the projection system projects into space an image of a pattern provided on a mask MA (or on a mask table fiducial plate) or an image provided by a SLM and having contrasting light and dark regions. The substrate table WT is then scanned horizontally (in one or two directions, e.g. the X and/or Y directions) and vertically so that the aperture of the TIS passes through the space where the aerial image is expected to be. This is known as the "blue align" phase. As the TIS aperture passes through the beam and the dark portions of the image of the pattern, the output of the photodetector will fluctuate (known as a Moiré effect). The vertical level at which the rate of change of amplitude of the photodetector output is highest indicates the level at which the image of the pattern has the greatest contrast and hence indicates the plane of optimum focus. The X,Y positions of the TIS aperture at which the rate of change of amplitude of the photodetector output during the horizontal scan is highest, are indicative of the aerial image's lateral position. The aerial image is then compared with subsequent resist layers in order to determine where to expose further alignment targets.

As will be described below, an alignment sensor (32) measures the alignment of a plurality of alignment targets on the substrate (20) with respect to an alignment target on the transmission image sensor (TIS) plate. The TIS alignment target is only used during the "blue align" phase. As mentioned above, the "blue align" phase is when the location of the aerial image of the alignment target is measured with respect to the TIS prior to exposure. During the over-exposure of the overlay target in the scribelane, the TIS alignment target is covered with blades in order to avoid printing the TIS target on the substrate. The main advantage of this is that latent overlay metrology may be carried out using an existing TIS sensor. The overlay target itself cannot be used to carry out the "blue align"; a further TIS target alongside the overlay target is required for this step.

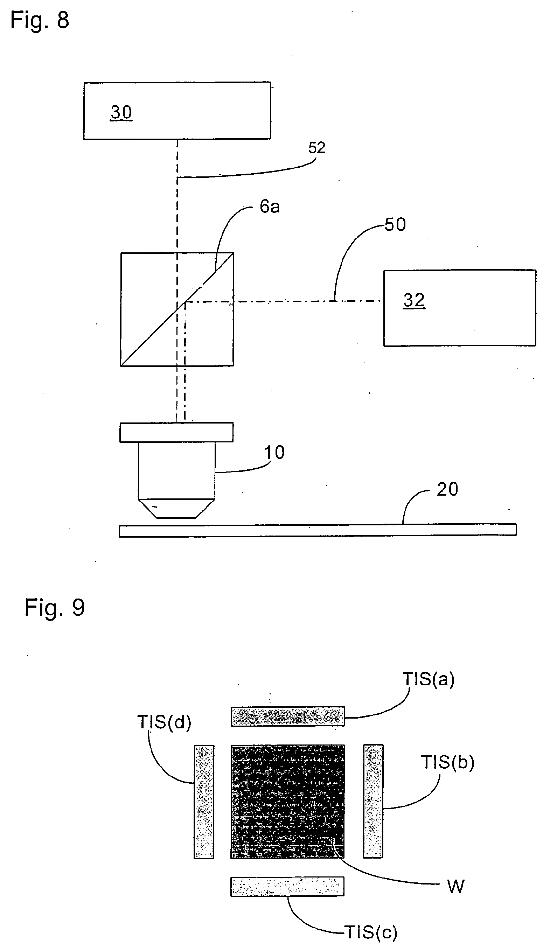

Figure 9 shows how the TIS targets TIS (a)-(d) surround the alignment target W. The symmetric configuration ensures that magnification errors can always be corrected for. Should spatial light modulators be used instead of masks, the TIS targets may be projected rather than included in the mask.

In an embodiment, the alignment sensor 32 is an off-axis alignment tool. It detects at least three sub-beams with different diffraction orders. The diffraction orders arise by the alignment mark (40a on the TIS, for instance) being a diffractive mark (such as a diffraction grating), which splits a beam into a number of sub-beams with different diffraction orders. Further alignment marks 40b are present on the substrate. The alignment sensor 32 measures the location of the substrate relative to the fiducial plate by aligning on targets 40a and 40b.

Turning to Figures 3a to 3d, the steps illustrated are: ,
i) aligning the substrate relative to the TIS fiducial;
ii) aligning the overlay aerial image relative to the TIS fiducial;
iii) overexposing the overlay aerial image in the resist layer to form the overexposed overlay target; and
iv) measuring the overlay between the overexposed overlay target and the underlying overlay target in the process layer.

The alignment sensor 32 is used to measure the substrate position via its alignment target with respect to the TIS position so that the miniature exposure unit may print an overlay target 42 at the correct position on the resist so that the scatterometer 30 will be able to measure the overlay (of one overlay target 42 with respect to an earlier overlay target 40b) most effectively. Targets can be imaged at the center of the image field of the objective where the imaging is virtually insensitive to drift in lateral magnification.

Knowing the alignment of the TIS with respect to the substrate 20 means that, by extrapolating the alignment of the TIS with respect to the resist layer 22, the alignment of the substrate and resist layers 20 and 22 with respect to each other can be determined in order to position the alignment target 42 on the correct place on the resist layer 22. Scribelanes are features of the substrate which will not have a pattern printed on them, but are intended for alignment purposes. They may contain the alignment marks 40.

As mentioned above, Figure 3a shows the first step of the overlay metrology according to an embodiment of the present invention. An alignment sensor 32 measures the alignment of a plurality of alignment targets on the substrate 20 with respect to a transmission image sensor TIS, measuring distances a and b (which are vectors measured with the alignment sensor). This step also contains process errors that occur during substrate alignment. Distances a and b are compared with reference distances to determine a distance vector associated with the substrate.

Figure 3b shows the measurement of a distance c, which is a distance between the center of the aerial image 50 and the "0-position" (i.e. the center of the reference grating) of the alignment sensor 32. The aerial image is used to measure the distance vector associated with the resist layer 22 in order that the miniature exposure unit may print a latent overlay target in the scribelane on the resist layer without exposing adjacent structures. This step mimics the mask alignment at the exposure position and eliminates drift in the scatterometer exposure branch. In order to monitor drift, the alignment marks 40b are, in an embodiment, phase-shift gratings.

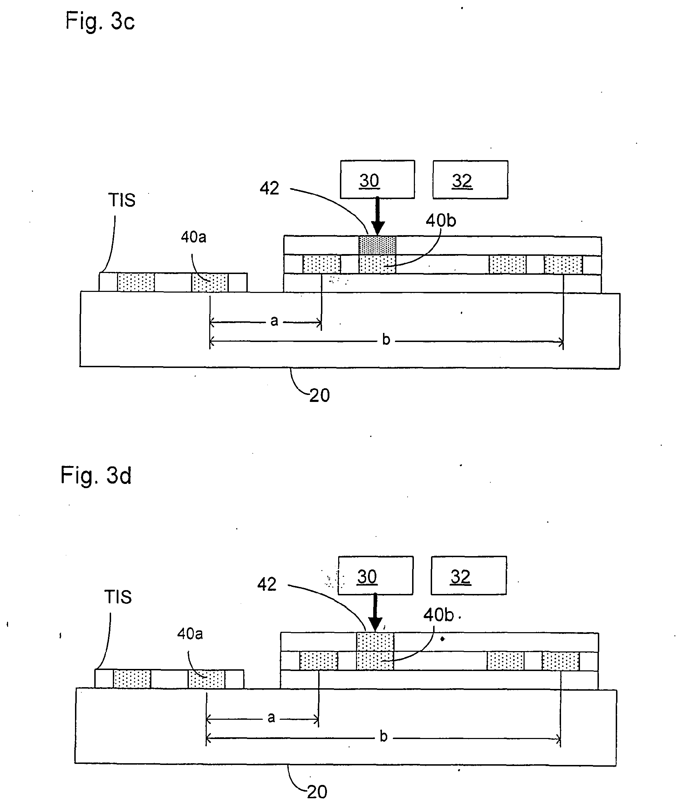

Figure 3c shows a step in which the scatterometer exposure branch (i.e. the miniature exposure unit) is used to over-expose (e.g. by a factor of 10 with respect to normal exposure levels) an overlay target 42 in the scribelane. The miniature exposure unit may be at a measurement position above the substrate. An illumination source and mask may be used to produce the overlay target, in which case a separate stage at an exposure position of a dual stage system enables overlay targets to be created without decreasing the throughput. In other words, the miniature exposure unit may be provided at a measurement position of a dual stage of a multiple substrate stage lithographic apparatus so that the miniature exposure unit, including the additional patterning device, can expose the overlay targets on a substrate at the same time as the projection system is projecting a patterned beam on another substrate at an exposure position of the multiple substrate stage lithographic apparatus. In an embodiment, however, the miniature exposure unit and the projection system may be provided at a substantially same position, in which case it may be advantageous to provide a separate source for the miniature exposure unit to facilitate throughput.

The miniature exposure unit with its additional patterning device need not have a moveable mask as its patterning device. An illumination source and a spatial light modulator (SLM) may be used to produce the overlay target. A SLM offers a programmable target and thus improves flexibility in the features of the target. The bit rate does not need to be high for a SLM to be usable by the miniature exposure unit. In this case, alignment targets no longer need to be printed in every field on the substrate, saving scribelane space. An advantage of using a SLM is that programmable targets may be printed. The targets therefore may be more similar to the features to be printed on the dies in the resist to better simulate the real resist behavior. The SLM may be used to print the target at a normal exposure dose instead of a higher exposure dose. The target should then be developed during a post exposure bake before being detectable with a scatterometer.

The target is printed in a position that is calculated from the measurements carried out by the alignment sensor 32 in the first two steps. The target 42 has the function of an alignment target and can be a programmable target in order to optimize the process without having to use new product masks in the case of new alignment targets. Various types of alignment targets can be printed and the most robust one used for the actual alignment. This may reduce costs since fewer masks may be needed, particularly in high-end applications where mask costs are high.

Figure 3d shows the measurement of the latent overlay between the substrate layer 22 containing target 42 and the substrate layer 20 containing the target 40 using the scatterometer 30. There is a stronger latent contrast due to the over-exposure in the third step, which makes the measurement quicker and more efficient. Latent overlay metrology detects process errors that occur in the substrate alignment.

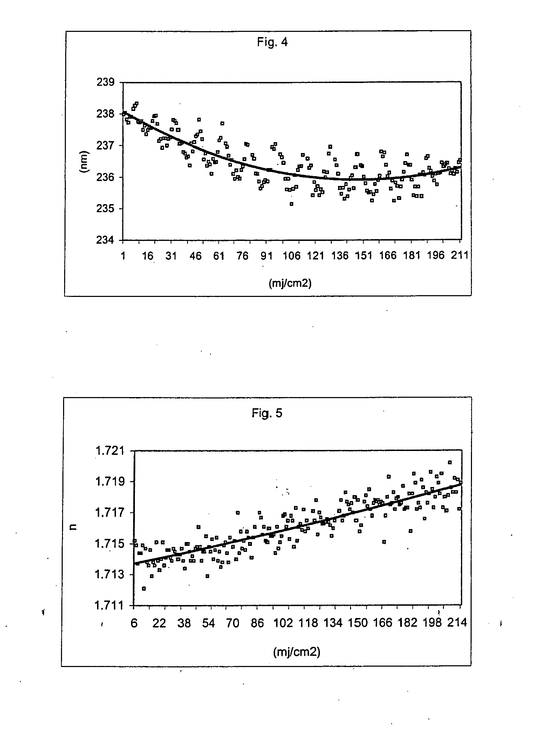

Figure 4 shows how the resist thickness of the latent image of the target 42 can be influenced by the exposure dose by which it was exposed with the miniature exposure unit. Figure 4 shows that at increasing dose, the resist gets thinner. For example, if the exposure dose is above 100 milliJoules per square centimeter (mJ/cm²) the exposed parts of the latent image of the target 42 show a decreased thickness of about 2 nm on the average relative to unexposed resist of the target 42 receiving an exposure dose of less than 1 mJ/cm². The difference in resist thickness can be used to measure the overlay between the latent image of the target 42 and the target 40 of substrate layer 20.

Additionally or alternatively, the change in refractive index (n) can be used to measure the overlay. Figure 5 shows how the refractive index of a latent image of a target 42 in resist varies with the exposure dose.

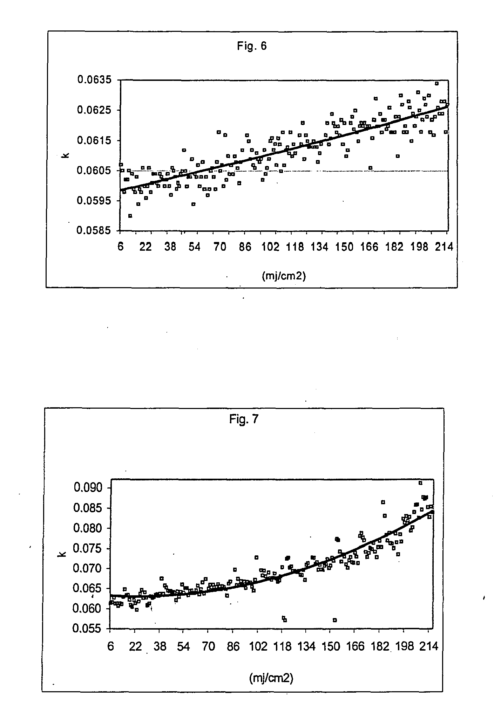

Figure 6 shows how the absorption coefficient of the latent image of a target 42 can be used to measure overlay. The absorption coefficient k of exposed and unexposed resist shows a difference in absorption that can be used to measure overlay. Using a post exposure bake can enhance this difference. Figure 7 shows the difference in absorption coefficient of resist as a function of exposed dose in mJ/cm² after a post exposure bake (PEB). One can see that if the latent image is over exposed with about 200 mJ/cm² and then is baked there is a difference of more than 20 % in absorption coefficient with substantially unexposed resist - this difference conveniently can be used to detect the overlay.

For the post exposure bake, a local post exposure bake station can be used in the lithographic projection apparatus as is described in US patent application 10/875,605, incorporated herein in is entirety by reference. The local post exposure bake station is configured to locally heat the substrate at the location of the target. Alternatively, a regular post exposure bake station can be used in the track or in the lithographic apparatus.

The resist in Figures 4-7 was designed for 193 nm radiation and the radiation used in the high-energy exposure unit should be designed for a wavelength of 193 nm. The term "normal" exposure dose refers to the dose normally supplied to the substrate underneath the projection system in the lithographic apparatus. The exposure dose may vary a little with resist, in general the "normal" exposure dose (En) of 193 nm resist is 15-30 mJ/cm², for 248 nm resist this would be 15-50 mJ/cm² and for 365 nm resist 50-200 mJ/cm². In general, the lower dose in the range will be used for bright field masks and the higher dose in the range for dark field masks. The high-energy exposure unit will supply a dose that is higher than the dose supplied by the projection system of the lithographic apparatus for the type of resist used. In an embodiment, the exposure dose would be a factor 5-100 higher than the "normal" exposure dose used during exposure in the lithographic apparatus. If the resist is suited for a different wavelength than used in the high-energy exposure unit, the exposure dose may be even a factor 10-150 higher than the "normal" exposure dose. Wavelengths used in the high-energy exposure unit may be 13 nm (EUV), 157 nm, 193 nm, 248 nm, 365 nm, 545 nm or 633 nm.

Because the over-exposure can take a relatively significant amount of time, a further embodiment of the present invention is shown in Figure 8. Figure 8 shows the metrology and exposure steps being done in parallel. The time taken to do the two steps is therefore at an absolute minimum. The exposure radiation and the metrology radiation have different wavelengths. Short wavelengths (less than 250 nm) are used for exposing the resist but cannot penetrate the bottom anti reflection coating (BARC). These wavelengths are therefore not suitable for overlay metrology. Longer wavelengths (greater than 300 nm) do not expose the resist, but penetrate the BARC layer which makes it suitable for overlay metrology.

Figure 8 shows the measurement branch 30 and the exposure branch 32 of a scatterometer. The two radiations 52 and 50 are either supplied separately or as a single multiwavelength beam or are combined in a dichroic beam splitter 6 before being input in a high-NA objective 10 and reflecting off the substrate 20. The reflected spectrum is then split into its component wavelengths again via the dichroic beam splitter so that the spectrum may be measured in the measurement branch 30 in order to determine the overlay of the substrate 20. Carrying out the measurement and the exposure in parallel gives a further advantage, which is that the evolution of the measured asymmetry as a function of time gives an indication of an offset in the asymmetry introduced by, for example, the process or the lithography tool. This information can therefore be used to correct the final measurement of the overlay.

Alternatively, a colour filter may be used to combine and split the exposure and metrology radiation.

The reduction in throughput caused by latent alignment verification may therefore be reduced to an absolute minimum. This is because the number of substrate table movements is reduced by a factor of 2. The exposure time can be reduced, while the signal to noise ratio of the measurement can be improved. The real time measurement of the asymmetry as a function of exposure time allows an accurate measurement of a residual process offset and/or a lithography tool offset. As mentioned above, this can be used to correct the final measurement result.

While specific embodiments of the invention have been described above, it will be appreciated that the invention may be practised otherwise than as described. The description is not intended to limit the invention.

## Claims

1. A lithographic apparatus, comprising:
an illumination system for conditioning a beam of radiation;
a support for to holding a patterning device, the patterning device for imparting the beam with a pattern in its cross-section;
a substrate table for holding a substrate;
a projection system for projecting the patterned beam onto a portion of the substrate; and
an exposure unit, including an additional patterning device, for printing a target onto the substrate.

2. The apparatus according to claim 1, wherein the projection system is arranged to project the patterned beam onto a portion of the substrate with a normal exposure dose, and
the exposure unit is a high-energy exposure unit for printing a target onto the substrate with a higher exposure dose than the normal exposure dose.

3. The apparatus according to claim 2, wherein the exposure dose of the high-energy exposure unit is 5 to 150 times higher than the normal exposure dose.

4. The apparatus according to claim 1, 2, or 3, wherein the exposure unit is associated with a scatterometer.

5. The apparatus according to claim 4, wherein the scatterometer is an angle-resolved high-numerical aperture scatterometer.

6. The apparatus according to any one of claims 1 to 5, wherein the exposure unit is configured to expose a target of a size less than 1 mm².

7. The apparatus according to any one of claims 1 to 5, wherein the exposure unit is configured to expose a target with a size less than 2500 µm² onto the scribelane of a substrate.

8. The apparatus according to any one of claims 1 to 7, wherein the exposure unit comprises a spatial light modulator configured to pattern the target.

9. The apparatus according to any one of claims 1 to 8, wherein the target comprises a latent phase-shift grating.

10. The apparatus according to any one of claims 1 to 9, further comprising a post exposure bake station configured to heat a substrate.

11. The apparatus according to claim 10, wherein the post exposure bake station is a local post exposure bake station configured to locally heat the substrate at the location of the target.

12. The apparatus according to any one of claims 1 to 11, wherein the exposure unit comprises a radiation source with a wavelength of 193 mm, 248 mm or 365 and an exposure dose of at least 30 mJ/cm².

13. The apparatus according to any one of claims 1 to 12, comprising a measuring position and an exposure position, wherein the exposure unit is at the measuring position.

14. A lithographic apparatus according to any one of claims 1 to 13, comprising a scatterometer for measuring the overlay of a substrate using the target printed by the additional exposure unit, wherein the projection system is arranged to project the patterned beam onto a portion of the substrate and the scatterometer is arranged to measure the overlay of the target on the substrate simultaneously.

15. A lithographic apparatus according to claim 14, comprising a dichroic beamsplitter for combining and splitting the respective wavelengths of the radiation beams associated with the projection system and the scatterometer.

16. A lithographic apparatus according to claim 14, comprising a colorfilter for combining and splitting the respective wavelengths of the radiation beams associated with the projection system and the scatterometer.

17. A lithographic apparatus according to any one of claims 14 to 16, wherein the scatterometer is arranged to emit a radiation beam with a longer wavelength than the projection system.

18. A lithographic apparatus according to claim 17, wherein the scatterometer is arranged to emit a radiation beam that is capable of passing through a bottom anti-reflection coating in the substrate without exposing a resist layer and the projection system is arranged to emit a radiation beam that is capable of exposing the resist layer but not passing through the bottom anti-reflection coating.

19. A lithographic apparatus according to claim 17 or 18, wherein the scatterometer is arranged to emit a radiation beam with a wavelength of at least 300 nm and the projection system is arranged to emit a radiation beam with a wavelength of less than 250 nm.

20. A lithographic apparatus according to any one of claims 1 to 19, comprising a plurality of transmission image sensor targets arranged on the patterning system.

21. A lithographic apparatus according to claim 20, wherein the transmission image sensor targets are symmetrically configured.

22. A lithographic apparatus according to claim 20 or 21, wherein the transmission image sensor targets surround the substrate target.

23. A lithographic apparatus according to claim 20, 21 or 22, wherein the patterning system comprises a mask and the transmission image sensor targets are part of the mask.

24. A lithographic apparatus according to claim 20, 21 or 22, wherein the patterning system comprises a spatial light modulator and the transmission image sensor targets are projected onto the substrate.

25. A method of measuring latent overlay of a resist layer with respect to a process layer on a substrate, comprising:
measuring a position of a substrate with respect to a reference;
exposing a target in the resist layer with beam of radiation having a high exposure dose in accordance with the measured position of the substrate; and
measuring the overlay of the resist layer with respect to the process layer at the exposed target.
